# EUROPÄISCHE PATENTSCHRIFT

(11) **EP 2 614 695 B1**
(45) Veröffentlichungstag und Bekanntmachung des Hinweises auf die Patenterteilung: **25.07.2018**
(21) Anmeldenummer: 11754373.6
(22) Anmeldetag: 06.09.2011
(51) Int. Cl.: H05K 7/14, H05K 5/00

(54) **SCHALTUNGSGEHÄUSE MIT EINER DARIN ÜBER POSITIONIERELEMENTE POSITIONIERTEN LEITERPLATTE**
CIRCUIT HOUSING HAVING A PRINTED CIRCUIT BOARD WHICH IS POSITIONED IN SAID CIRCUIT HOUSING BY MEANS OF POSITIONING ELEMENTS
BOÎTIER DE CIRCUIT ABRITANT UNE CARTE À CIRCUITS IMPRIMÉS POSITIONNÉE SUR DES ÉLÉMENTS DE POSITIONNEMENT

(30) Priorität: 09.09.2010 DE 102010044909
(43) Veröffentlichungstag der Anmeldung: 17.07.2013
(73) Patentinhaber: KNORR-BREMSE Systeme für Nutzfahrzeuge GmbH, 80809 München (DE)
(72) Erfinder: STÖHR, Rainer, 96524 Föritz (DE); REGN, Stefan, 91284 Neuhaus (DE); KAPTUR, Fabian, 73489 Jagstzell (DE)
(74) Vertreter: Schönmann, Kurt
(86) Internationale Anmeldenummer: PCT/EP2011/065363
(87) Internationale Veröffentlichungsnummer: WO 2012/032027

(56) Entgegenhaltungen:
- DE-A1- 10 348 979
- US-A- 4 672 732
- US-A- 5 979 037
- US-A1- 2008 165 510

## Beschreibung

Die Erfindung betrifft ein Schaltungsgehäuse gemäß dem Oberbegriff von Anspruch 1.

Ein gattungsgemäßes Schaltungsgehäuse ist aus der DE 20 2008 008 286 U1 bekannt, wobei dort am Schaltungsgehäuse ausgebildete zapfenartige Positionierelemente mit kreisrundem Querschnitt in zugeordnete Bohrlöcher in der Leiterplatte ragen. Ein weiteres gattungsgemäßes Schaltungsgehäuse ist aus US 2008/0165510 A1 bekannt.

Elektronische Steuergeräte von Fahrzeugen wie Bremssteuergeräte, Motorsteuergeräte und dergleichen weisen meist eine hohe Anzahl von elektrischen Steckkontakten auf, welche beispielsweise in das Schaltungsgehäuse im Rahmen eines Kunststoffspritzvorgangs eingespritzt oder eingestitcht sind und endseitig in Öffnungen oder Kontaktstellen einer Leiterplatte eingelötet oder eingepresst werden müssen. Dabei ist die Lage der Leiterplatte relativ zu dem Schaltungsgehäuse entscheidend, da bei fehl positionierten Leiterplatten die vom Boden des Schaltungsgehäuses weg ragenden elektrischen Steckkontakte nicht mehr mit den zugeordneten Öffnungen oder Kontaktstellen an der Leiterplatte fluchten. Deshalb werden hohe Anforderungen an die Toleranzen der Leiterplatte und der Positionierelemente am Schaltungsgehäuse gestellt, welche sich besonders bei großen Abmessungen der Leiterplatte bzw. des Schaltungsgehäuses als problematisch Einzuhalten und teuer zu Fertigen herausgestellt haben.

Gemäß US 5 979 037 A sind in einem Rahmen einer elektronischen Baugruppe zwei Bohrungen ausgebildet, in welche Zapfen eines Gehäuses ragen. Von den Zapfen besteht ein Zapfen aus zwei Rippen, welche zusammen in Bezug zur zugeordneten Bohrung den gleichen Außendurchmesser aufweisen. Der andere Zapfen hat demgegenüber einen geringeren Durchmesser als die zugeordnete Bohrung, so dass zwar ein gewisser Abstandsausgleich in einer Richtung zwischen den beiden Bohrungen gesehen vorhanden ist, jedoch der Rahmen gegenüber dem Gehäuse weiterhin verschwenkt werden kann.

Der Erfindung liegt demgegenüber die Aufgabe zugrunde, ein Schaltungsgehäuse mit wenigstens einer darin angeordneten Leiterplatte der eingangs erwähnten Art derart fortzubilden, dass eine möglichst genaue Positionierung der Leiterplatte an oder in dem Schaltungsgehäuse mit hohen Toleranzanforderungen möglich ist.

### Offenbarung der Erfindung

Der Erfindung liegt der Gedanke zugrunde, dass ein weiteres, in einer weiteren Bohrung der Leiterplatte aufgenommenes Positionierelement durch wenigstens eine Ausnehmung voneinander getrennte, in oder durch die weitere Bohrung ragende, quer zur Richtung einer gedachten Verbindungslinie der Bohrungen elastisch ausgebildete Spreizfinger aufweist, welche einen derartigen Querschnitt aufweisen, dass
a) in Richtung der gedachten Verbindungslinie gesehen zwischen ihnen und einer radial inneren Umfangsfläche der weiteren Bohrung jeweils beidseitig ein Spiel vorhanden ist,
b) sie aber mit ihren diametral gegenüber liegenden Seitenflächen jeweils lediglich entlang einer Kontaktlinie oder eines Kontaktpunktes die radial innere Umfangsfläche der weiteren Bohrung senkrecht zur gedachten Verbindungslinie spielfrei kontaktieren.

Insgesamt wird daher der Drehfreiheitsgrad der Leiterplatte in Bezug zu dem Schaltungsgehäuse, welcher sich aus dem Zusammenspiel des einen Positionierelements mit der einen Bohrung ergeben würde, durch das Zusammenwirken des weiteren Positionierelements mit der weiteren Bohrung gesperrt, indem das weitere Positionierelement senkrecht zur Verbindungslinie in der weiteren Bohrung spielfrei bzw. unter einer Presspassung aufgenommen ist. Die spielbehaftete Aufnahme des weiteren Positionierelements in der weiteren Bohrung in Richtung der Verbindungslinie gesehen ermöglicht demgegenüber einen Toleranzausgleich.

Die mit diesen Maßnahmen erzielbaren Vorteile sind darin zu sehen, dass die Leiterplatte dann zunächst an dem einen Positionierelement, welches in die eine, kreisrunde Bohrung ragt, um dieses eine Positionierelement in einer Ebene senkrecht zu dem einen Positionierelement drehbar gelagert wäre und dass dieser Drehfreiheitsgrad senkrecht zur Verbindungslinie durch die spielfreie Aufnahme des weiteren Positionierelements in der weiteren Bohrung gesperrt wird. Weil das weitere Positionierelement zusätzlich einen von einem kreisrunden Querschnitt abweichenden Querschnitt hat und zugleich noch beidseitig der Spreizfinger dieses Positionierelements noch jeweils ein Abstand (Spiel) zur radial inneren Umfangsfläche der weiteren Bohrung vorhanden ist, kann in Richtung der Verbindungslinie zwischen beiden Bohrungen gesehen ein Toleranzausgleich stattfinden, insbesondere dadurch, dass das weitere Positionierelement unter elastischer Verformung der Spreizfinger und unter Verkleinerung der Ausnehmung zwischen den Spreizfingern entlang der gedachten Verbindungslinie gesehen eine Bewegungsmöglichkeit relativ zu der weiteren Bohrung hat. Diese Bewegungsmöglichkeit des weiteren Positionierelements innerhalb der weiteren Bohrung stellt dann einen Toleranzausgleich zur Verfügung, falls die vom Boden des Gehäuseteils weg ragenden elektrischen Steckkontakte nicht genau mit den Öffnungen in der Leiterplatte fluchten sollten.

Damit wird es möglich, anstatt wie zum Toleranzausgleich beim Stand der Technik üblich, als weitere Bohrung bevorzugt kein Langloch vorzusehen, welches in die Leiterplatte gefräst werden müsste, sondern wie die eine Bohrung ebenfalls als Bohrung mit kreisrundem Querschnitt vorzusehen, welche demgegenüber günstiger durch Bohren zu fertigen ist.

Diese Konstellation ist möglich, weil die Spreizfinger anstatt mit ihrer gesamten Umfangsfläche die radial innere Umfangsfläche der weiteren und vorzugsweise kreisrunden Bohrung nur mit einer Kontaktlinie bzw. mit einem Kontaktpunkt kontaktieren. Beispielsweise ist der Querschnitt, den die beiden Spreizfinder miteinander ausbilden, im Wesentlichen elliptisch, wobei der Kontakt mit der radial inneren Umfangsfläche der weiteren Bohrung dann an der großen Achse der Ellipse vorhanden ist.

Durch die in den Unteransprüchen aufgeführten Maßnahmen sind vorteilhafte Weiterbildungen und Verbesserungen der in Anspruch 1 angegebenen Erfindung möglich.

Wie oben bereits erwähnt, ist gemäß einer besonders zu bevorzugenden Ausführungsform vorgesehen, dass die weitere Bohrung einen kreisrunden Querschnitt mit einem Durchmesser aufweist, welcher kleiner als der Abstand der Kontaktlinien oder Kontaktpunkte voneinander senkrecht zur gedachten Verbindungslinie ist. Dann wird eine Presspassung zwischen dem weiteren Positionierungselement und der weiteren Bohrung in einer Richtung senkrecht zur Verbindungslinie verwirklicht. Alternativ könnte die weitere Bohrung auch als Langloch ausgebildet sein.

Gemäß einer Weiterbildung kann wenigstens die weitere Bohrung als Durchgangsbohrung ausgebildet sein und sich die Ausnehmung zwischen den Spreizfingern des weiteren Positionierelements in Axialrichtung der weiteren Bohrung gesehen ein Stück weit über eine obere und eine untere Fläche der Leiterplatte hinaus erstrecken. In diesem Fall ist eine gute Bewegungsmöglichkeit der Spreizfinger gegeben, um mögliche Toleranzen auszugleichen.

Beispielsweise ist wenigstens eines der Positionierelemente mit dem Schaltungsgehäuse als einstückiges Spritzgussformteil aus Kunststoff ausgebildet.

Besonders bevorzugt liegt die Leiterplatte in ihrer an den Positionierelementen positionierten Lage auf wenigstens drei Auflageflächen des Lagergehäuses auf. Um eine möglichst ebene Auflage ohne Verkippen zu garantieren, sind diese Auflageflächen möglichst weit voneinander entfernt angeordnet. Wenn die Ausdehnung der Auflageflächen klein gewählt wird, kann ihre Lage innerhalb des Spritzgusswerkzeugs leicht verändert werden, wodurch sehr enge Toleranzen bezüglich der Ebenheit ihrer Lage erreicht werden können.

Gemäß einer weiteren Maßnahme sind die Spreizfinger des weiteren Positionierelements mit elastischer Vorspannung gegen die radial innere Umfangsfläche der weiteren Bohrung gespannt. Dadurch wird eine spielfreie, nach Art einer Presspassung ausgebildete reibschlüssige Verbindung zwischen dem weiteren Positionierelement und der weiteren Bohrung ausgebildet, welche dann zusätzlich zur Positionierung der Leiterplatte relativ zu dem Schaltungsgehäuse auch eine Befestigungsfunktion übernehmen kann.

Besonders bevorzugt weist deshalb auch das eine Positionierelement wenigstens drei Spreizfinger auf, deren zur radial inneren Umfangsfläche der einen Bohrung weisenden Außenflächen in einem Kontaktbereich von einer gedachten Zylinderfläche umhüllt sind und welche unter elastischer Vorspannung gegen die radial innere Umfangsfläche der einen Bohrung gespannt sind. Diese eine Bohrung bzw. dieses eine Positionierelement ist dann spielfrei im Gegensatz zu dem weiteren Positionierelement, welches sich innerhalb der weiteren Bohrung allerdings nur in Richtung der gedachten Verbindungslinie zwischen den Bohrungen zum Toleranzausgleich bewegen kann.

Die oben beschriebenen erfindungsgemäßen Wirkungen treten ein, wenn wenigstens eine der Bohrungen als Durchgangsbohrung ausgebildet ist.

Weitere die Erfindung verbessernde Maßnahmen werden nachstehend gemeinsam mit der Beschreibung von Ausführungsbeispielen der Erfindung anhand der Zeichnung näher dargestellt.

### Zeichnung

In der Zeichnung zeigt
- Fig.1: eine perspektivische Ansicht eines Schaltungsgehäuses mit Positionierelementen gemäß einer bevorzugten Ausführungsform der Erfindung;
- Fig.2: das Schaltungsgehäuse von Fig.1 mit einer über die Positionierelemente positionierten Leiterplatte in perspektivischer Ansicht;
- Fig.3.: eine Draufsicht auf das Schaltungsgehäuse mit montierter Leiterplatte von Fig.2;
- Fig.4: eine perspektivische Ansicht eines Positionierelements;
- Fig.5: eine Draufsicht auf das Positionierelement von Fig.4;
- Fig.6: eine perspektivische Ansicht eines weiteren Positionierelements;
- Fig.7: eine Draufsicht auf das Positionierelement von Fig.6;
- Fig.8: eine Querschnittsdarstellung des Positionierelements von Fig.5.

### Beschreibung des Ausführungsbeispiels

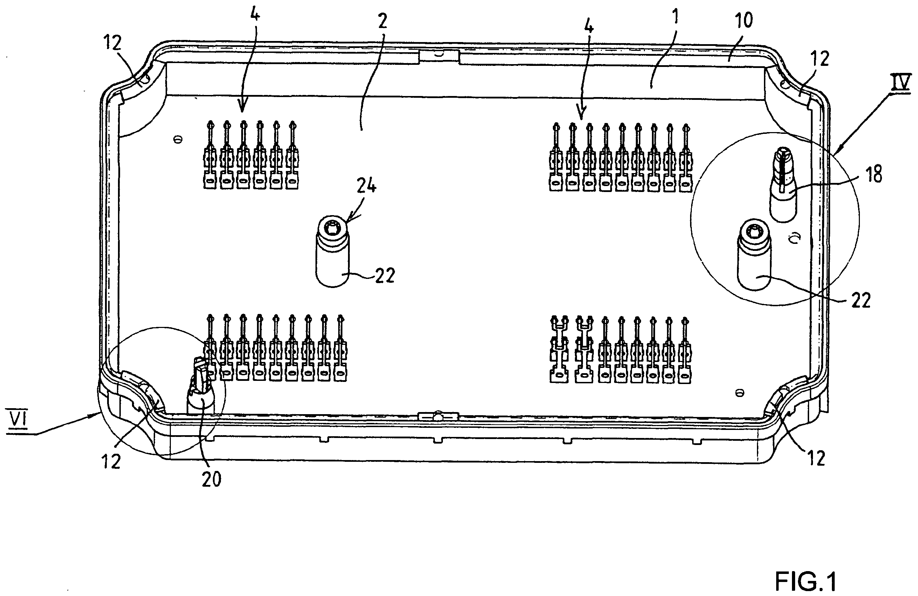

Fig.1 zeigt ein Schaltungsgehäuse eines Steuergeräts eines Fahrzeugs, genauer ein unteres, schüsselförmiges Gehäuseteil 1, welches mit einem weiteren hier nicht gezeigten oberen Gehäuseteil zusammensetzt das Schaltungsgehäuse bildet. Von einem Boden 2 des unteren Gehäuseteils 1 ragen elektrische Steckkontakte 4 weg, welche zum Einstecken in Öffnungen 6 einer Leiterplatte 8 und beispielsweise anschließendem Verlöten oder Einpressen ohne Löten ("stitchen") bestimmt sind. Die Leiterplatte 8 wird zur Montage auf eine am oberen Rand des Gehäuseteils 1 ausgebildete Auflageflächen 12 sowie auf Schraubdome 22 aufgelegt. Um eine möglichst ebene Auflage ohne Verkippen zu garantieren, sind die Auflageflächen 12 möglichst weit voneinander entfernt angeordnet.

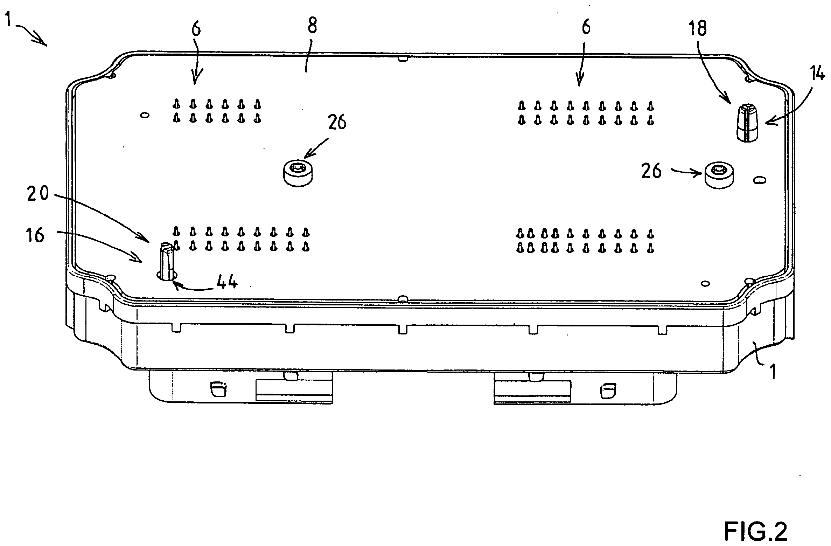

Wie Fig.2 zeigt, weist die Leiterplatte 8 neben den Öffnungen 6 für die elektrischen Steckkontakte 4 eine hier nicht explizit gezeigte elektrische Schaltung und beispielsweise zwei Bohrungen 14, 16 auf, in welche von dem Boden 2 des Gehäuseteils 1 weg nach oben ragende zapfenartige Positionierelemente 18, 20 wenigstens zum Zwecke der Positionierung der Leiterplatte 8 relativ zu dem Gehäuseteil 1 in der Fügeebene eingreifen.

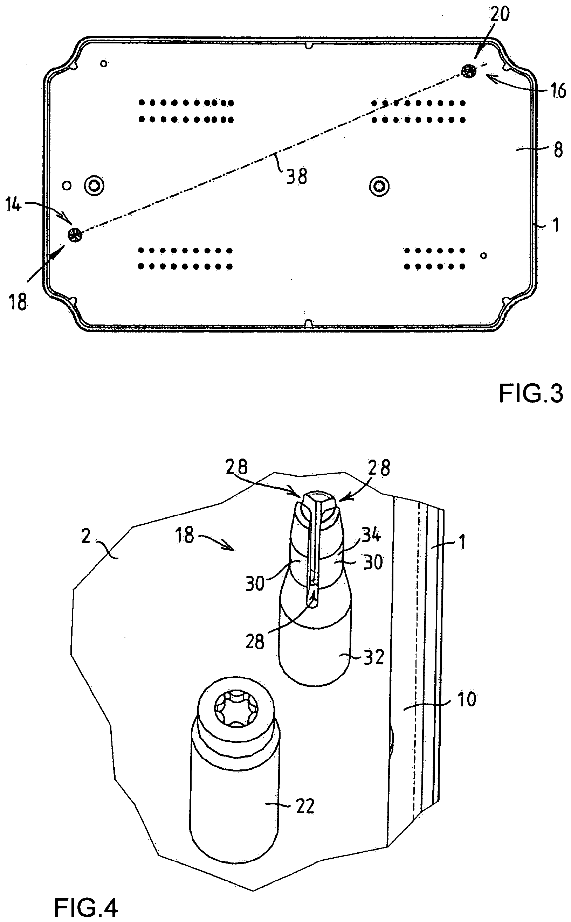

Die Leiterplatte 8 hat wie das Gehäuseteil 1 einen im Wesentlichen rechteckigen Querschnitt, wobei die Bohrungen 14, 16 für die Positionierelemente 18, 20 im Wesentlichen in Nachbarschaft zu einer Diagonalen der Leiterplatte 8 liegen, damit sie einen möglichst großen Abstand voneinander aufweisen, wie Fig.3 zeigt.

Die beiden Bohrungen 14, 16 weisen bevorzugt einen kreisrunden Querschnitt auf und sind vorzugsweise als Durchgangsbohrungen ausgebildet, so dass sie von den Positionierelementen 18, 20 durchragt werden. Die Bohrungen 14, 16 könnten auch als Langlöcher ausgebildet sein.

Weiterhin sind die beiden zapfenartigen Positionierelemente 18, 20 mit dem Gehäuseteil 1 beispielsweise als einstückiges Spritzgussformteil aus Kunststoff ausgebildet (Fig.1). Alternativ könnten sie auch separate Teile bilden, die mit entsprechenden Aufnahmen im Gehäuseteil 1 stoff-, reib- und/oder formschlüssig verbunden sind.

Zudem ragen Befestigungsdome 22 vom Boden des Gehäuseteils nach oben, mit Öffnungen 24, welche zum Eingriff beispielsweise von Schrauben vorgesehen sind, die durch entsprechende Löcher 26 in der Leiterplatte 8 ragen, um die Leiterplatte 8 gegen die Auflageflächen der Schraubdome 22 zu kontern, wie anhand von Fig.1 und Fig.2 leicht vorstellbar ist.

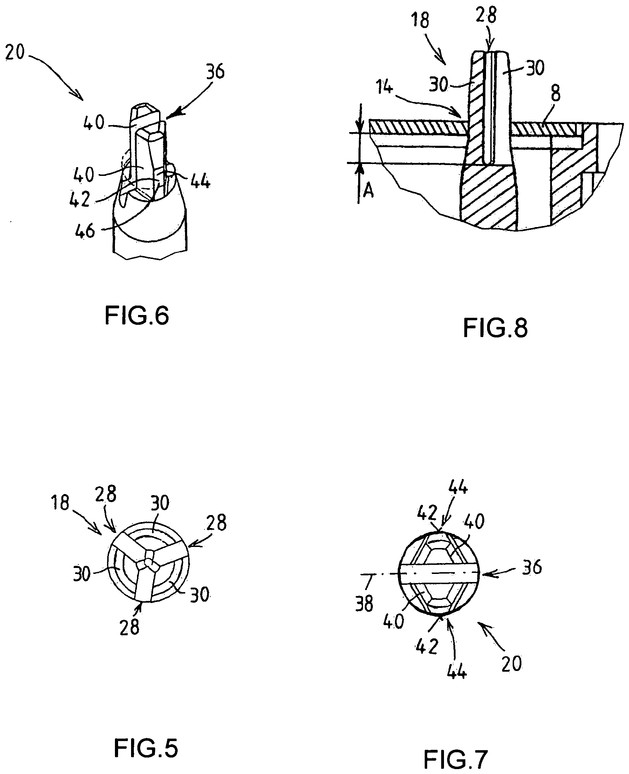

Wie aus Fig.4 und Fig.5 hervorgeht, weist besonders bevorzugt das eine Positionierelement 18 wenigstens drei durch nutartige Ausnehmungen 28 getrennte Spreizfinger 30 auf, wobei sich der Querschnitt, den sie zusammen ausbilden, ausgehend von der gehäuseseitigen zapfenartigen Basis 32 des bis zu seinem freien Ende konisch, beispielsweise stufenartig verjüngt. Im Kontaktbereich 34 mit der einen Bohrung 14 ist dieser Querschnitt bevorzugt zylindrisch mit konstantem Durchmesser, wobei die Spreizfinger 30 im Kontaktbereich 34 dann Zylindersegmente ausbilden, welche von einer gedachten Zylinderfläche umhüllt sind (Fig.4).

Die Außenflächen der Spreizfinger 30 sind im Kontaktbereich 34 unter elastischer Vorspannung gegen die radial innere Umfangsfläche der einen Bohrung 14 gespannt (Fig.2). Mit anderen Worten ist im eingesteckten Zustand des einen Positionierelements 18 in der einen Bohrung 14 der Innendurchmesser der einen Bohrung 14 etwas kleiner als der Außendurchmesser der gedachten, die Spreizfinger 38 im Kontaktbereich 34 umhüllenden Zylinderfläche. Somit ragt das eine Positionierelement 18 nach Art einer Presspassung durch die eine Bohrung 14 spielfrei hindurch, wobei die Spreizfinger 30 unter Verkleinerung der Ausnehmungen 28 nach innen elastisch einfedern, wie insbesondere auch aus Fig.8 hervorgeht.

Wie aus Fig.6 und Fig.7 hervorgeht, weist das durch die weitere, bevorzugt kreisrunde Bohrung 16 ragende weitere Positionierelement 20 bevorzugt zwei, durch beispielsweise eine nutartige Ausnehmung 36 voneinander getrennte, quer zur Richtung einer gedachten Verbindungslinie 38 der beiden Bohrungen 14, 16 (Fig.3) elastisch ausgebildete Spreizfinger 40 auf.

Diese beiden Spreizfinger 40 weisen einen derartigen Querschnitt auf, dass in Richtung der gedachten Verbindungslinie 38 gesehen zwischen ihnen und einer radial inneren Umfangsfläche der weiteren Bohrung 16 jeweils beidseitig ein Abstand vorhanden ist (siehe Fig.2) und sie mit ihren diametral gegenüber liegenden Seitenflächen 42 jeweils lediglich entlang einer Kontaktlinie 44 oder eines Kontaktpunktes die radial innere Umfangsfläche der weiteren Bohrung 16 senkrecht zur gedachten Verbindungslinie 38 spielfrei kontaktieren. Beispielsweise ist der Querschnitt, den die beiden Spreizfinger miteinander in einem Kontaktbereich 46 mit der weiteren Bohrung 16 ausbilden, im Wesentlichen elliptisch, wie in Fig.7 angedeutet, wobei der Kontakt mit der radial inneren Umfangsfläche der weiteren Bohrung 16 dann an der großen Achse der Ellipse in einem ballig ausgeformten Bereich 44 linienartig bzw. punktartig vorhanden ist.

Weiterhin erstreckt sich bei dem einen Positionierelement 18 wie bei dem weiteren Positionierelement 20 die Ausnehmung 28, 36 zwischen den Spreizfingern 30, 40 in Axialrichtung der Bohrungen 14, 16 gesehen ein Stück weit über eine obere und eine untere Fläche der Leiterplatte 8 hinaus, wie Fig.2 und Fig.8 zeigen. Der Grund der Ausnehmungen 28, 36 hat beispielsweise einen Abstand A von der unteren Fläche der leiterplatte 8, wie Fig.8 zeigt.

Darüber hinaus sind die Spreizfinger 40 des weiteren Positionierelements 20 mit elastischer Vorspannung gegen die radial innere Umfangsfläche der weiteren Bohrung 16 gespannt. Mit anderen Worten ist der Innendurchmesser der weiteren Bohrung 16 im Kontaktbereich 46 etwas kleiner als die große Achse des elliptischen Querschnitts. Dadurch wird eine spielfreie, nach Art einer Presspassung ausgebildete reibschlüssige Verbindung zwischen dem weiteren Positionierelement 20 und der weiteren Bohrung 16 quer zur Verbindungslinie 38 ausgebildet, welche zusätzlich zur Positionierung der Leiterplatte 8 relativ zu dem Gehäuseteil 1 auch eine Befestigungsfunktion übernimmt. Zusätzlich sind die Spreizfinger 40 des weiteren Positionierelementes 20 in ihrem über den Kontaktbereich 46 hinaus ragenden Endbereich im Querschnitt bevorzugt konisch verjüngt, um ein Einführen in die weitere Bohrung 16 zu erleichtern.

Weil das weitere Positionierelement 20 einen von einem kreisrunden Querschnitt abweichenden Querschnitt hat und zugleich noch beidseitig der Spreizfinger 40 in Richtung der Verbindungslinie 38 gesehen noch beidseitig jeweils ein Abstand zur radial inneren Umfangsfläche der weiteren Bohrung 16 vorhanden ist, kann in Richtung der Verbindungslinie 38 gesehen ein Toleranzausgleich stattfinden, insbesondere dadurch, dass das weitere Positionierelement 20 unter elastischer Verformung der Spreizfinger 40 und unter Verkleinerung der Ausnehmung 36 zwischen den Spreizfingern 40 entlang der gedachten Verbindungslinie 38 eine Bewegungsmöglichkeit relativ zu der weiteren Bohrung 16 hat.

Diese Bewegungsmöglichkeit des weiteren Positionierelements 20 innerhalb der weiteren Bohrung 16 bzw. umgekehrt stellt einen Toleranzausgleich zur Verfügung, welcher aufgrund der Entfernungstoleranzen Bohrung 14 zu Bohrung 16 und Positionierelement 18 zu Positionierelement 20 notwendig ist.

Die Position des Positionierelements 18 mit der zugehörigen spielfreien Bohrung 14 in der Leiterplatte 8 und der Richtung zum weiteren Positionierelement 20 mit der zugehörigen Bohrung 16 bzw. Langloch 16 bilden die Basis eines Koordinatensystems zur Positionierung der Öffnungen 6 in der Leiterplatte 8 zu den zugehörigen Steckkontakten 4 im Boden 2 des Gehäuseteils 1. Dadurch reduzieren sich die Toleranzen der Komponenten beim Zusammenbau der Baugruppe.

Anstatt mit kreisrundem Querschnitt könnte die weitere Bohrung 16 daher auch als Langloch ausgebildet sein, wobei dann ebenfalls ein Kontakt entlang einer Kontaktlinie bzw. an einem Kontaktpunkt vorhanden ist. Die reibschlüssigen Verbindungen durch Presspassung zwischen den Positionierelementen 18, 20 und den Bohrungen 14, 16 trägt ebenfalls zur Befestigung der Leiterplatte 8 an dem Gehäuseteil 1 bei. Im Extremfall könnte auf die zusätzlichen Verschraubungen verzichtet werden.

### Bezugszeichenliste

1 Gehäuseteil
2 Boden
4 Steckkontakte
6 Öffnungen
8 Leiterplatte
10 Stufe
12 Auflageflächen
14 Bohrung
16 Bohrung
18 Positionierelement
20 Positionierelement
22 Befestigungsdome
24 Öffnungen
26 Löcher
28 Ausnehmungen
30 Spreizfinger
32 Basis
34 Kontaktbereich
36 Ausnehmung
38 Verbindungslinie
40 Spreizfinger
42 Seitenfläche
44 Kontaktlinie
46 Kontaktbereich

## Patentansprüche

1. Schaltungsgehäuse (1) mit wenigstens einer darin angeordneten Leiterplatte (8), die eine elektrische Schaltung und wenigstens zwei Bohrungen (14, 16) aufweist, in welche von dem Schaltungsgehäuse (1) weg ragende zapfenartige Positionierelemente (18, 20) wenigstens zum Zwecke einer Positionierung der Leiterplatte (8) relativ zu dem Schaltungsgehäuse (1) eingreifen, wobei von den Positionierelementen (18, 20) wenigstens ein Positionierelement (18, 20) in eine kreisrunde Bohrung der Bohrungen spielfrei ragt und von einem Boden des Schaltungsgehäuses (1) elektrische Steckkontakte (4) wegragen, welche zum Einstecken in Öffnungen (6) der Leiterplatte (8) bestimmt sind, **dadurch gekennzeichnet, dass** ein weiteres, in einer weiteren Bohrung (16) der Bohrungen (14, 16) aufgenommenes Positionierelement (20) durch wenigstens eine Ausnehmung (36) voneinander getrennte, in oder durch die weitere Bohrung (16) ragende, quer zur Richtung einer gedachten Verbindungslinie (38) der Bohrungen (14, 16) elastisch ausgebildete Spreizfinger (40) aufweist, welche einen derartigen Querschnitt aufweisen, dass
a) in Richtung der gedachten Verbindungslinie (38) gesehen zwischen den Spreizfingern und einer radial inneren Umfangsfläche der weiteren Bohrung (16) jeweils beidseitig ein Spiel vorhanden ist,
b) die Spreizfingern aber mit ihren diametral gegenüber liegenden Seitenflächen (42) jeweils lediglich entlang einer Kontaktlinie (44) oder eines Kontaktpunktes die radial innere Umfangsfläche der weiteren Bohrung (16) senkrecht zur gedachten Verbindungslinie (38) spielfrei kontaktieren.

2. Schaltungsgehäuse nach Anspruch 1, **dadurch gekennzeichnet, dass** die weitere Bohrung (16) einen kreisrunden Querschnitt mit einem Durchmesser aufweist, welcher kleiner als der Abstand der Kontaktlinien (44) oder Kontaktpunkte voneinander senkrecht zur gedachten Verbindungslinie (38) ist.

3. Schaltungsgehäuse nach Anspruch 1, **dadurch gekennzeichnet, dass** die weitere Bohrung (16) als Langloch ausgebildet ist.

4. Schaltungsgehäuse nach einem der vorhergehenden Ansprüche, **dadurch gekennzeichnet, dass** wenigstens die weitere Bohrung (16) als Durchgangsbohrung ausgebildet ist und sich die Ausnehmung (36) zwischen den Spreizfingern (40) des weiteren Positionierelements (20) in Axialrichtung der weiteren Bohrung (16) gesehen über eine obere und eine untere Fläche der Leiterplatte (8) hinaus erstreckt.

5. Schaltungsgehäuse nach einem der vorhergehenden Ansprüche, **dadurch gekennzeichnet, dass** wenigstens eines der Positionierelemente (18, 20) mit dem Schaltungsgehäuse (1) als einstückiges Spritzgussformteil aus Kunststoff ausgebildet ist.

6. Schaltungsgehäuse nach einem der vorhergehenden Ansprüche, **dadurch gekennzeichnet, dass** die Leiterplatte (8) in ihrer an den Positionierelementen (18, 20) positionierten Lage auf wenigstens drei Auflageflächen (12) des Schaltungsgehäuses (1) aufliegt.

7. Schaltungsgehäuse nach einem der vorhergehenden Ansprüche, **dadurch gekennzeichnet, dass** die Spreizfinger (40) des weiteren Positionierelements (20) mit elastischer Vorspannung gegen die radial innere Umfangsfläche der weiteren Bohrung (16) gespannt sind.

8. Schaltungsgehäuse nach einem der vorhergehenden Ansprüche, **dadurch gekennzeichnet, dass** die Leiterplatte (8) an oder in dem Schaltungsgehäuse (1) mittels der mit in den zugeordneten Bohrungen (14, 16) reibschlüssig gehaltenen Positionierelemente (18, 20) und/oder durch zusätzliche Verbindungsmittel (22, 24) gehalten ist.

9. Schaltungsgehäuse nach einem der vorhergehenden Ansprüche, **dadurch gekennzeichnet, dass** die Bohrungen (14, 16) bezogen auf die flächige Ausdehnung der Leiterplatte (8) einen möglichst großen Abstand voneinander aufweisen.

10. Schaltungsgehäuse nach einem der vorhergehenden Ansprüche, **dadurch gekennzeichnet, dass** das eine Positionierelement (18) wenigstens drei Spreizfinger (30) aufweist, deren zur radial inneren Umfangsfläche der einen Bohrung (14) weisenden Außenflächen in einem Kontaktbereich (34) von einer gedachten Zylinderfläche umhüllt sind und welche unter elastischer Vorspannung gegen die radial innere Umfangsfläche der einen Bohrung (14) gespannt sind.

11. Schaltungsgehäuse nach einem der vorhergehenden Ansprüche, **dadurch gekennzeichnet, dass** wenigstens eine der Bohrungen (14, 16) als Durchgangsbohrung oder als Sacklochbohrung ausgebildet ist.

## Claims

1. Circuit housing (1) having at least one printed circuit board (8) which is arranged in said circuit housing and has an electrical circuit and at least two holes (14, 16) in which peg-like positioning elements (18, 20) which project away from the circuit housing (1) engage at least for the purpose of positioning the printed circuit board (8) relative to the circuit housing (1), wherein at least one positioning element (18, 20) from amongst the positioning elements (18, 20) projects without play into one circular hole from amongst the holes and electrical plug contacts (4) project away from a base of the circuit housing (1), said electrical plug contacts being intended to be inserted into openings (6) in the printed circuit board (8), **characterized in that** a further positioning element (20), which is accommodated in a further hole (16) from amongst the holes (14, 16), has spreading fingers (40) which are separated from one another by at least one recess (36), project into or through the further hole (16), are designed to be elastic transverse to the direction of an imaginary connecting line (38) of the holes (14, 16) and have a cross section of such a kind that
a) as seen in the direction of the imaginary connecting line (38), there is play between the spreading fingers and a radially inner circumferential surface of the further hole (16) on both sides in each case,
b) but the spreading fingers make contact by way of their diametrically opposite side faces (42) with the radially inner circumferential face of the further hole (16) perpendicular to the imaginary connecting line (38) without play only along a contact line (44) or a contact point in each case.

2. Circuit housing according to Claim 1, **characterized in that** the further hole (16) has a circular cross section with a diameter which is smaller than the distance between the contact lines (44) or contact points perpendicular to the imaginary connecting line (38).

3. Circuit housing according to Claim 1, **characterized in that** the further hole (16) is in the form of an elongate hole.

4. Circuit housing according to one of the preceding claims, **characterized in that** at least the further hole (16) is in the form of a passage hole and the recess (36) between the spreading fingers (40) of the further positioning element (20), as seen in the axial direction of the further hole (16), extends beyond an upper and a lower face of the printed circuit board (8).

5. Circuit housing according to one of the preceding claims, **characterized in that** at least one of the positioning elements (18, 20), together with the circuit housing (1), is in the form of an integral plastic injection-molded part.

6. Circuit housing according to one of the preceding claims, **characterized in that** the printed circuit board (8), in the situation in which it is positioned on the positioning elements (18, 20), is supported on at least three support faces (12) of the circuit housing (1).

7. Circuit housing according to one of the preceding claims, **characterized in that** the spreading fingers (40) of the further positioning element (20) are stressed with elastic prestress against the radially inner circumferential face of the further hole (16).

8. Circuit housing according to one of the preceding claims, **characterized in that** the printed circuit board (8) is held on or in the circuit housing (1) by means of the positioning elements (18, 20), which are held in a frictionally engaging manner with in the associated holes (14, 16), and/or by additional connecting means (22, 24).

9. Circuit housing according to one of the preceding claims, **characterized in that** the holes (14, 16) are at the greatest possible distance from one another in relation to the flat extent of the printed circuit board (8).

10. Circuit housing according to one of the preceding claims, **characterized in that** one positioning element (18) has at least three spreading fingers (30), the outer faces of said spreading fingers which face the radially inner circumferential face of the one hole (14) being enclosed by an imaginary cylindrical surface in a contact region (34) and said spreading fingers being stressed with elastic prestress against the radially inner circumferential face of the one hole (14).

11. Circuit housing according to one of the preceding claims, **characterized in that** at least one of the holes (14, 16) is in the form of a passage hole or in the form of a blind hole.

## Revendications

1. Boîtier (1) de circuit, comprenant au moins une plaquette (8) à circuit imprimé, qui y est disposée et qui a un circuit électrique et au moins deux trous (14, 16), dans lesquels, au moins en vue d'une mise en position de la plaquette (8) à circuit imprimé par rapport au boîtier (1) de circuit, pénètrent des éléments (18, 20) de mise en position de type en tenon faisant saillie en s'éloignant du boîtier (1) de circuit, dans lequel, parmi les éléments (18, 20) de mise en position, au moins un élément (18, 20) de mise en position pénètre sans jeu dans un trou de section circulaire parmi les trous et, d'un fond du boîtier (1) de circuit, font saillie, en s'en éloignant, des contacts (4) électriques à enfichage, qui sont destinés à s'enficher dans des ouvertures (6) de la plaquette (8) à circuit imprimé, **caractérisé en ce qu'**un autre élément (20) de mise en position, reçu dans un autre trou (16) parmi les trous (14, 16), a des doigts (40) d'écartement, constitués de manière élastique, séparés l'un de l'autre par un évidement (36), passant dans l'autre trou (16) ou le traversant, transversalement à la direction d'une ligne (38) imaginaire de liaison des trous (14, 16), qui ont une section transversale telle que
a) considéré dans la direction de la ligne (38) imaginaire de liaison, il y a un jeu, respectivement, des deux côtés entre les doigts d'écartement et une surface périphérique intérieure radialement de l'autre trou (16),
b) les doigts d'écartement contactent toutefois sans jeu, perpendiculairement à la ligne (38) imaginaire de liaison, par leurs surfaces (42) latérales opposées diamétralement, respectivement seulement le long d'une ligne (44) de contact ou d'un point de contact, la surface périphérique intérieure radialement de l'autre trou (16).

2. Boîtier de circuit suivant la revendication 1, **caractérisé en ce que** l'autre trou (16) a une section transversale circulaire d'un diamètre, qui est plus petit que la distance entre les lignes (44) de contact ou les points de contact, perpendiculairement à la ligne (38) imaginaire de liaison.

3. Boîtier de circuit suivant la revendication 1, **caractérisé en ce que** l'autre trou (16) est constitué en boutonnière.

4. Boîtier de circuit suivant l'une des revendications précédentes, **caractérisé en ce qu'**au moins l'autre trou (16) est constitué en trou traversant et l'évidement (36) s'étend entre les doigts (40) d'écartement de l'autre élément (20) de mise en position, considéré dans la direction axiale de l'autre trou (16), au-delà d'une surface supérieure et d'une surface inférieure de la plaquette (8) à circuit imprimé.

5. Boîtier de circuit suivant l'une des revendications précédentes, **caractérisé en ce qu'**au moins l'un des éléments (18, 20) de mise en position est constitué avec le boîtier (1) de circuit sous la forme d'une pièce moulée par injection d'une seule pièce en matière plastique.

6. Boîtier de circuit suivant l'une des revendications précédentes, **caractérisé en ce que** la plaquette (8) à circuit imprimé repose, dans sa position placée sur les éléments (18, 20) de mise en position, sur au moins trois surfaces (12) de support du boîtier (1) de circuit.

7. Boîtier de circuit suivant l'une des revendications précédentes, **caractérisé en ce que** les doigts (40) d'écartement de l'autre élément (20) de mise en position sont précontraints élastiquement sur la surface périphérique intérieure radialement de l'autre trou (16).

8. Boîtier de circuit suivant l'une des revendications précédentes, **caractérisé en ce que** la plaquette (8) à circuit imprimé est retenue sur ou dans le boîtier (1) de circuit au moyen des éléments (18, 20) de mise en position maintenus à frottement dans les trous (14, 16) associés et/ou par des moyens (22, 24) supplémentaires de liaison.

9. Boîtier de circuit suivant l'une des revendications précédentes, **caractérisé en ce que** les trous (14, 16) ont, rapportés à l'étendue en surface de la plaquette (8) à circuit imprimé, un intervalle entre eux aussi grand que possible.

10. Boîtier de circuit suivant l'une des revendications précédentes, **caractérisé en ce que** le un élément (18) de mise en position a au moins trois doigts (30) d'écartement, dont les surfaces extérieures, tournées vers la surface périphérique intérieure radialement du un trou (14), sont enveloppés, dans une région (34) de contact, d'une surface cylindrique imaginaire et qui sont précontraints élastiquement sur la surface périphérique intérieure radialement du un trou (14).

11. Boîtier de circuit suivant l'une des revendications précédentes, **caractérisé en ce qu'**au moins l'un des trous (14, 16) est constitué sous la forme d'un trou traversant ou d'un trou borgne.
